# EUROPEAN PATENT SPECIFICATION

(11) **EP 2 833 345 B1**
(45) Date of publication and mention of the grant of the patent: **16.10.2019**
(21) Application number: 13768766.1
(22) Date of filing: 22.03.2013
(51) Int. Cl.: A45C 11/00, A45C 13/10

(54) **DISPLAY CONVEYING DEVICE**
ANZEIGETRANSPORTVORRICHTUNG
DISPOSITIF DE TRANSPORT D'AFFICHEUR

(30) Priority: 29.03.2012 JP 2012075420
(43) Date of publication of application: 04.02.2015
(73) Proprietor: NEC Corporation, Tokyo 108-8001 (JP)
(72) Inventor: EBE, Shinichi, Minato-ku, Tokyo 1088001 (JP); YANAGISAWA, Makoto, Minato-ku, Tokyo 1088001 (JP)
(74) Representative: Vossius & Partner Patentanwälte Rechtsanwälte mbB
(86) International application number: PCT/JP2013/001942
(87) International publication number: WO 2013/145664

(56) References cited:
- DE-A1- 19 828 193
- JP-A- H 119 325
- JP-A- 2002 280 753
- JP-A- 2004 016 360
- JP-A- 2005 136 580
- JP-A- 2005 145 452
- JP-A- 2005 217 895
- JP-A- 2007 022 618
- JP-A- 2008 294 179
- JP-U- H0 531 315
- US-A- 4 255 001
- US-A- 6 129 237
- US-A1- 2005 254 352
- US-A1- 2009 017 883
- US-A1- 2012 043 235

## Description

### [Technical Field]

The present invention relates to a display carrier for carrying a display such as a flat panel display.

### [Background Art]

Chances to carry a display represented by a flat panel display for a meeting or a presentation at a customer's office and the like are increasing. Such display is not necessarily tough against an external factor such as sunlight, dust, temperature, humidity or an impact due to its fall. Therefore, in the case of the carrying, there is adopted a method to cover a display with a display cover formed of rubber or the like, or to store a display in a storage case formed of metal or the like. Document US 6 129 237 A discloses such a display carrier.

In patent literature 1, there is a description about a technology in which all means for performing enlarged display of a still picture and an animation are stored in a portable case.

In patent literature 2, there is a description about a technology which makes carrying of a system easy by, after installing, connecting and adjusting all pieces of configuration equipment and components in an operable state, storing them in a single rack in a folded manner.

### [Citation List]

### [Patent Literature]

[Patent literature 1] Japanese Patent Application Laid-Open No. H05 (1993)-100314
[Patent literature 2] Japanese Utility Model Patent No. 3087540

### [Summary of Invention]

### [Technical Problem]

In the case of the above-mentioned display cover, it usually has a structure to make only a display part be exposed because operability cannot be sacrificed. In other words, the above-mentioned display cover has some degree of effect on an impact by a fall or the like, but cannot block dust and sunlight off completely.

On the other hand, because the above-mentioned storing case is of a structure to store the whole of a display, the display can be protected from most of external factors. However, in the case of a general storage case, it merely stores the display. Accordingly, the display may move inside the storing case. By this, there is a possibility that an outer wall of the display and an inner wall of the storage case are rubbed with each other, and the outer wall of the display is damaged.

The technology of patent literature 1 is a technology to store a complete set of equipment for performing expanded projection of an image, and is not a technology for storing a general display mentioned above. Accordingly, in the technology of patent literature 1, there is a possibility that the display moves inside a case when storing the general display mentioned above. That is, in the technology of patent literature 1, the general display mentioned above cannot be protected from an external factor and thus cannot be carried safely.

An object to be stored in a rack in patent literature 2 is a system under a condition that all pieces of configuration equipment and components are installed, connected and adjusted in a operable state (specifically, a computer system including a camera, a display, a printer and the like), and thus it is not the general display mentioned above. Accordingly, in the technology of patent literature 2, there is a possibility that the display will move in the inside of the case, when the general display mentioned above is stored in the case. That is, in the technology of patent literature 2, the general display mentioned above cannot be protected from an external factor and cannot be carried safely.

The present invention has been made in order to settle the above-mentioned problem, and provides a display carrier capable of carrying the general display safely.

### [Solution to Problem]

A display carrier of the present invention comprises the features of appended independent claims 1-3.

Meanwhile, various components of the present invention do not need to be entities independent of each other necessarily, and thus cases that: a plurality of components are formed as one member; one component is formed of a plurality of members; a certain component is a part of another component; and a part of a certain component and a part of another component overlap with each other are also allowed.

### [Advantageous Effects of Invention]

According to the present invention, a display can be carried safely.

### [Brief Description of Drawings]

Fig. 1 indicates a trihedral figure of a display carrier according to an illustrative example, which does not form part of the present invention under a condition that a display is stored in a storage box and a window part is closed by a closing member.
Fig. 2 indicates a trihedral figure of a display carrier according to the example of figure 1, which does not form part of the present invention under a condition that a display is stored in a storage box and a window part is not closed by a closing member.
Fig. 3 indicates a perspective view of a display carrier according to the example of figure 1, which does not form part of the present invention under a condition that a window part is closed by a closing member.
Fig. 4 indicates an exploded perspective view of a display carrier according to the example of figure 1, which does not form part of the present invention under a condition that a display is stored in a storage box, the storage box is placed vertically, and a window part is not closed by a closing member.
Fig. 5 indicates an exploded perspective view of a display carrier according to the first exemplary embodiment of the present invention for describing a supporting method of a closing member by a supporting member.
Fig. 6 indicates a perspective view of a display carrier according to a second exemplary embodiment of the present invention under a condition that a window part is closed.
Fig. 7 indicates a perspective view of a display carrier according to the second exemplary embodiment of the present invention under a condition that a window part is exposed.
Fig. 8 indicates a perspective view of a display carrier according to a third exemplary embodiment of the present invention under a condition that a window part is closed.
Fig. 9 indicates a perspective view of a display carrier according to the third exemplary embodiment of the present invention under a condition that a window part is exposed.
Fig. 10 indicates a perspective view of a display carrier according to a fourth exemplary embodiment of the present invention under a condition that a window part is closed.
Fig. 11 indicates a perspective view of a display carrier according to the fourth exemplary embodiment of the present invention under a condition that a window part is exposed.

### [Description of Embodiments]

### (First exemplary embodiment)

### (Description of a structure)

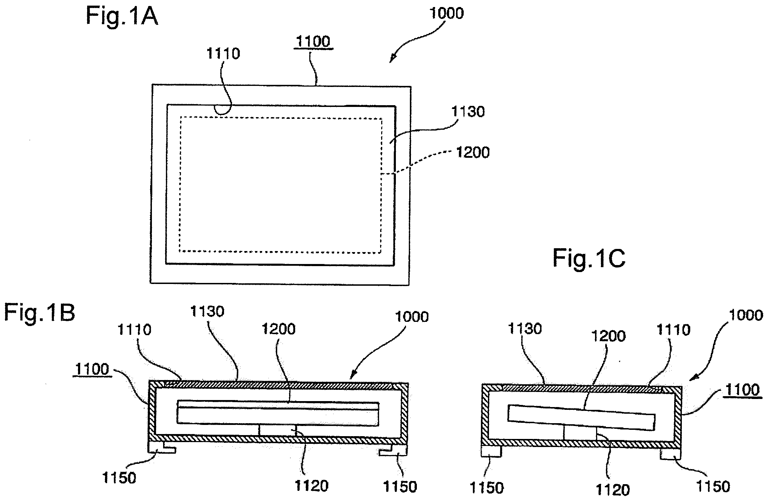

The first exemplary embodiment of the present invention will be described below with reference to Figs. 1 to 5. A display carrier 1000 of this exemplary embodiment has a storage box 1100, a fixing member 1120 and a closing member 1130.

The storage box 1100 stores a display 1200 having a display screen 1210. The fixing member 1120 fixes the display 1200 inside the storage box 1100.

A window part 1110 for visually recognizing the display screen 1210 from outside is formed in a face of the storage box 1100 facing the display screen 1210 of the display 1200 which has been fixed. The closing member 1130 closes the window part 1110.

The display 1200 is a liquid crystal display or a plasma display of a panel shape, for example. The display screen 1210 is formed into a quadrangle shape (a rectangle, for example).

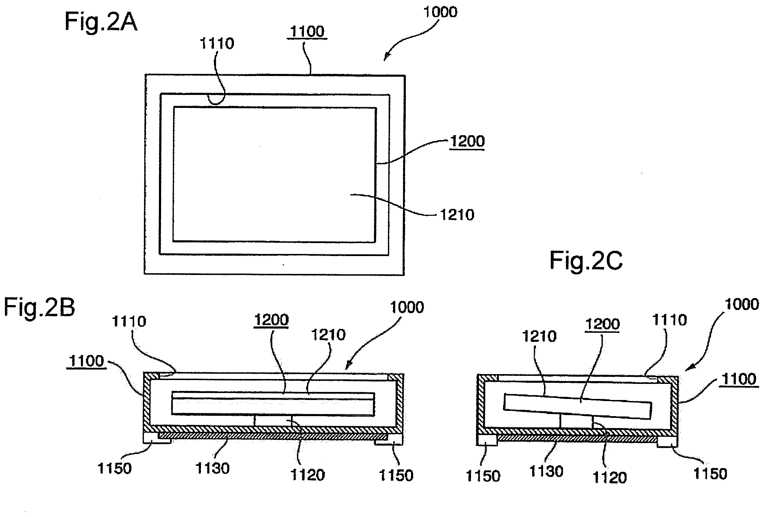

As shown in Fig. 1 and Fig. 2, the storage box 1100 is formed into a hollow structure that accommodates the display 1200. The window part 1110 is usually formed as a quadrangle-shape penetration hole having a size which allows the whole display screen 1210 to be visually recognized (in other words, a size that the display 1200 can be taken in and out).

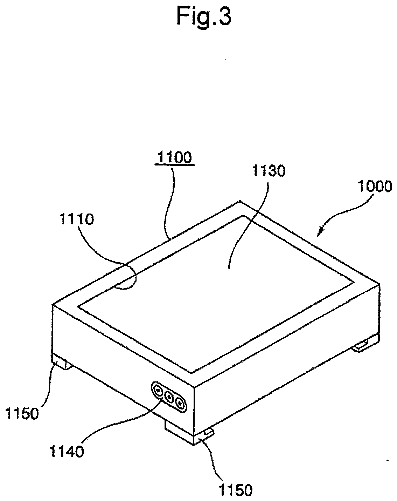

As shown in Figs. 3 to 5, a connection connector 1140 for connecting a cable which is an interface to an external device (not illustrated; a cellular phone or a laptop computer, for example) is formed at a predetermined position of the storage box 1100. In the inside of the storage box 1100, the connection connector 1140 and the display 1200 are connected directly or via a cable.

The fixing member 1120 is provided at a predetermined position inside the hollow of the storage box 1100. The fixing member 1120 may be integrally formed with the storage box 1100. Alternatively, the fixing member 1120 may be separated from the storage box 1100, and, at the time of assembly, may be joined to the storage box 1100 by a predetermined joining method. The rear surface (a face opposite to the display screen 1210) of the display 1200 is joined to the fixing member 1120 by a predetermined connecting method (a self-adhesive tape, for example). As a result, the display 1200 does not move in the hollow of the storage box 1100. In this case, the display 1200 is fixed on a position where an outside surface of the display 1200 does not touch an inside surface of the storage box 1100.

The upper surface of the fixing member 1120 is not parallel to the window part 1110, and inclines at a predetermined angle. Accordingly, the fixing member 1120 fixes the display 1200 such that the display screen 1210 will be in a state that it is inclined relative to the window part 1110 at a predetermined angle.

In this exemplary embodiment, the closing member 1130 is formed by one plate-like member. The closing member 1130 can be attached to and detached from a sealing member (rubber packing, for example) formed in the periphery of the window part 1110.

A supporting member 1150 to support the closing member 1130 attachably and detachably is provided in a face of the storage box 1100 opposite to the face in which the window part 1110 is formed on a face of the storage box 1100 opposite to the face in which the window part 1110 is formed.

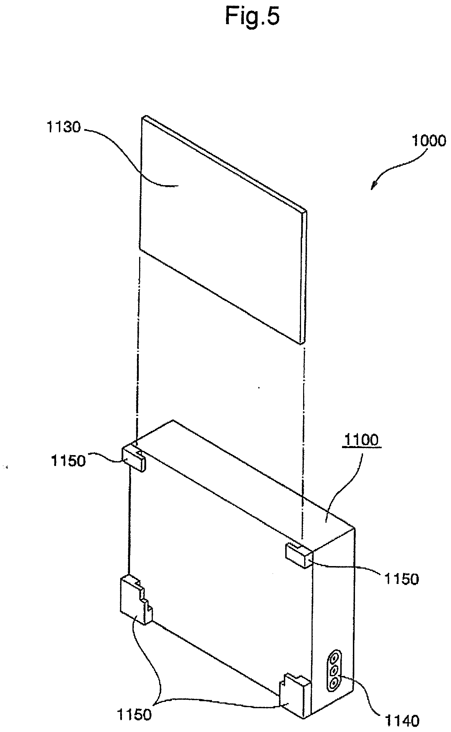

For example, as shown in Fig. 5, pieces of supporting member 1150 are formed in the four corners of the under surface of the storage box 1100. When the storage box 1100 is placed vertically (such that the window part 1110 is placed substantially vertically), the closing member 1130 should be loaded by being slid from the upper side to the lower side in the back of the storage box 1100.

The supporting member 1150 not only stores the closing member 1130 removed from the window part 1110, but also becomes a leg part of the storage box 1100 itself when the storage box 1100 is placed horizontally (such that the window part 1110 is placed substantially horizontally) as shown in Fig. 1 and Fig. 2.

It is preferred to form the storage box 1100 and the closing member 1130 by a high rigidity material (resin and aluminum alloy, for example) or the like because it is possible to protect the display 1200 from an external shock more certainly. Also, it is preferred to form the storage box 1100 and the closing member 1130 by a material excellent in thermal insulating properties because temperature of the display 1200 can be kept constant.

### (Description about a series of work from storing a display to visual recognition)

When it is confirmed that the closing member 1130 is removed and the window part 1110 is open, the display 1200 is stored inside the storage box 1100 from the window part 1110 and is fixed to the fixing member 1120. Next, the window part 1110 is closed by the closing member 1130. Accordingly, as shown in Fig. 1 and Fig. 3, the display 1200 is sealed by the storage box 1100 and the closing member 1130. When the display 1200 is in such state, the display 1200 is carried by the display carrier 1000.

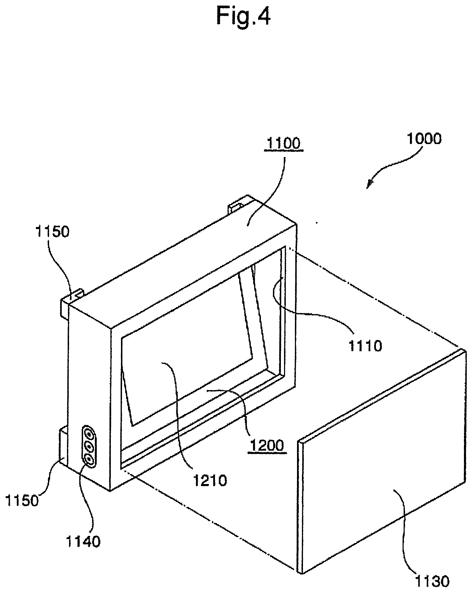

When the carrying is completed and the display 1200 is used (when a meeting or presentation is conducted at a customer's site, for example), the closing member 1130 is removed from the window part 1110. The storage box 1100 is placed vertically (refer to Fig. 4) so as to make the window part 1110 be in an approximately vertical state. The display screen 1210 of the display 1200 is exposed to the window part 1110 of the storage box 1100.

In this state, a plug cable of a data output device such as a portable terminal is connected to the connection connector 1140, and information (image data, for example) is outputted to the data output device. Users (people who participate in a meeting, for example) can visually recognize information indicated on the display screen 1210 via the window part 1110.

Meanwhile, as shown in Fig. 2 and Fig. 5, the closing member 1130 that has been removed is supported by the supporting member 1150 formed in the back of the storage box 1100.

### (Description of an effect)

In the case of the display carrier 1000 of this exemplary embodiment, the display 1200 stored in the storage box 1100 can be sealed from outside because the window part 1110 is closed by the closing member 1130. Therefore, the display 1200 can be protected from an external factor. The display 1200 is fixed by the fixing member 1120. Therefore, the display 1200 does not move in the inside of the storage box 1100. Accordingly, a risk of damages of an outer wall of the display 1200 due to rubbing of the outer wall of the display 1200 with an inner wall of the storage box 1100 is avoided. In this case, when fixing the display 1200 at a position with which its outside does not touch an inside face of the storage box 1100, even if an impact acts on the storage box 1100 during the carrying, it is possible to prevent this impact from acting on the display 1200 directly.

In summary, a general display (a liquid crystal display or a plasma display of a panel shape, for example) can be carried safely according to this exemplary embodiment.

The closing member 1130 can be attached to and detached from a sealing member formed in the periphery of the window part 1110 (rubber packing, for example). As a result, it becomes possible to improve airtightness in the storage box 1100 while maintaining workability about attachment/detachment of the closing member 1130.

In addition, in the case of this exemplary embodiment, information which is indicated on the display screen 1210 can be visually recognized under a condition that the display 1200 is stored in the storage box 1100 without being taken out from the storage box 1100.

The fixing member 1120 fixes the display 1200 such that the display screen 1210 is inclined relative to the window part 1110. For this reason, as shown in Fig. 4, the display screen 1210 will be in a backward-tilting state when the storage box 1100 is placed vertically. Therefore, visibility of the display screen 1210 can be improved.

The window part 1110 is formed as a penetration hole. Accordingly, when the display 1200 is a display of a touch panel type, for example, a user can touch the display screen 1210. That is, operability of a display is not deteriorated.

Further, as shown in Fig. 5, the storage box 1100 has the supporting member 1150 to support the closing member 1130 attachably and detachably in a face opposite to the window part 1110. For this reason, the closing member 1130 removed from the window part 1110 does not become an obstacle, and loss of the removed closing member 1130 can also be prevented. Moreover, as shown in Fig. 3, when the storage box 1100 is placed horizontally, the supporting member 1150 also functions as a leg part of the storage box 1100.

Meanwhile, the present invention is not limited to this exemplary embodiment, and various modifications are permitted within the range that does not deviate from the scope of the present invention. For example, in the above-mentioned embodiment, it has been illustrated that the display carrier 1000 is formed by storing the display 1200 that is general in the storage box 1100 and fixing it using the fixing member 1120. However, a portable type display device in which a dedicated display is stored in the storage box 1100 at the time of production and fixed by the fixing member 1120 can be also implemented.

Also, in this exemplary embodiment, it has been illustrated that the window part 1110 includes a penetration hole. However, such image-visible window part may be sealed by a translucent plate such as glass and resin (not shown).

### (Second exemplary embodiment)

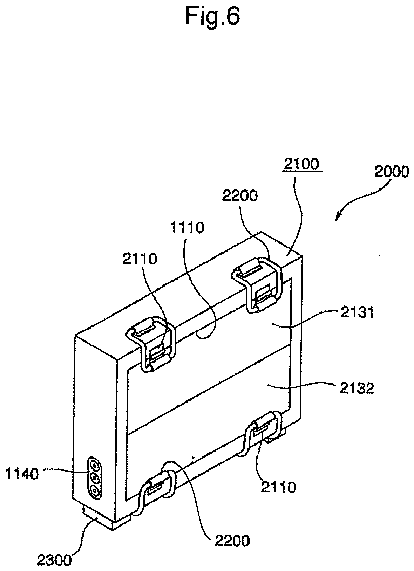

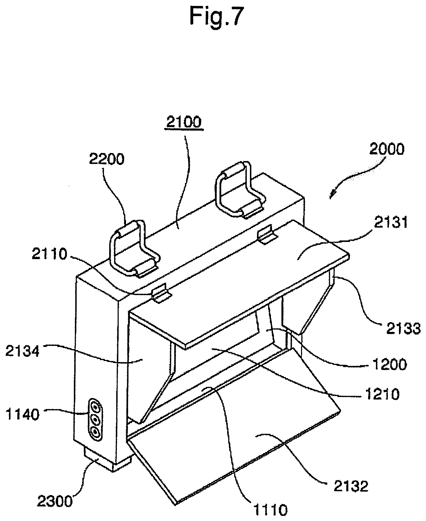

Each of Fig. 6 and Fig. 7 indicates a perspective view of a display carrier 2000 according to the second exemplary embodiment of the present invention. Fig. 6 is a perspective view of a state that the window part is closed, and Fig. 7 is a perspective view of a state that the window part is exposed. Meanwhile, Fig. 6 and Fig. 7 indicate the state that the display carrier 2000 is placed vertically.

The display carrier 2000 includes a pair of upper and lower closing members 2131 and 2132. The closing member 2131 is rotatably attached to the upper end part of the window part 1110 via a hinge mechanism 2110. The closing member 2132 is rotatably attached to the lower end part of the window part 1110 via the hinge mechanism 2110.

Further, as shown in Fig. 7, the display carrier 2000 includes a pair of right and left closing members 2133 and 2134. The closing member 2133 is rotatably attached to the right end part of the window part 1110 via a hinge mechanism (not shown). The closing member 2134 is rotatably attached to the left end part of the window part 1110 via a hinge mechanism (not shown). About attachment positions of the pair of right and left closing members 2133 and 2134, these are attached at positions deeper than attachment positions of the pair of upper and lower closing members 2131 and 2132 by a certain amount (an amount corresponding to the plate thickness of the closing members 2131 and 2132, for example).

As shown in Fig. 7, the closing member 2131 is held by the pair of right and left closing members 2133 and 2134 when it is open.

In the upper part and the lower part of a storage box 2100, there is provided a stopper 2200 for fixing movement of the pair of upper and lower closing members 2131 and 2132 in order to maintain closing of the pair of upper and lower closing members 2131 and 2132 when it is closed. There is provided a leg part 2300 for preventing interference between the stopper 2200 and a floor surface is formed in the lower part of the storage box 2100.

According to the second exemplary embodiment described above, the same effect as the first exemplary embodiment can be obtained.

Furthermore, in the case of the second exemplary embodiment, because the closing members 2131, 2133 and 2134 also function as a light shielding structure to prevent the surrounding ambient light, visibility of the display screen 1210 is improved.

The closing members 2131, 2132, 2133 and 2134 are in a state that they are connected with the storage box 2100 by hinge mechanisms, and thus they are not separated. Accordingly, there is no need to worry about tidying and their loss.

Meanwhile, by applying antireflection coating to the inner walls of the closing member 2131, 2133 and 2134 and the storage box 2100, a diffused reflection in the inner walls of the closing members 2131, 2132, 2133 and 2134 and the storage box 2100 is prevented, and thus visibility of the display screen 1210 is improved further.

Meanwhile, although there are a plurality of closing members (a total of four: 2131, 2132, 2133 and 2134) in the second exemplary embodiment described above, the number of closing members may be one only if it is rotatably connected to the storage box 2100 via a hinge mechanism.

### (Third exemplary embodiment)

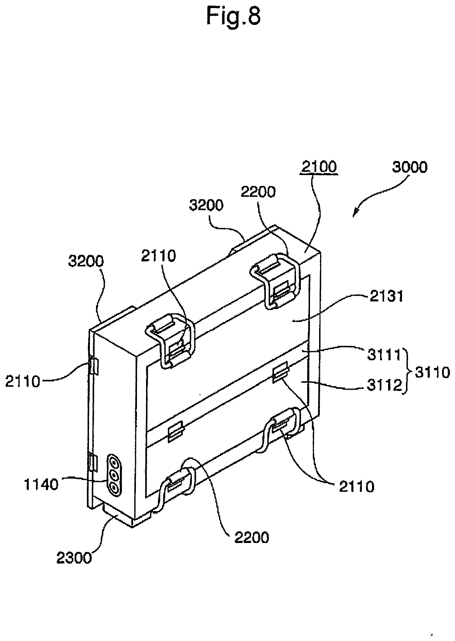

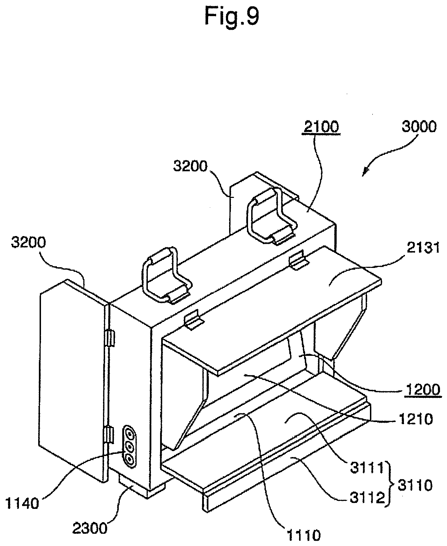

Fig. 8 and Fig. 9 indicate perspective views of a display carrier 3000 according to the third exemplary embodiment of the present invention, respectively. Fig. 8 is a perspective view of a state that a window part is closed, and Fig. 9 is a perspective view of a state that the window part is exposed. Meanwhile, Fig. 8 and Fig. 9 indicate a state where the display carrier 3000 is placed vertically.

The structure of the display carrier 3000 is identical with the display carrier 2000 except for a part. Accordingly, an identical reference symbol is given to an identical component, and description about such components will be omitted.

In the display carrier 3000, an underside closing member 3110 is divided into two pieces: a first closing part 3111 and a second closing part 3112. The first closing part 3111 and the second closing part 3112 are rotatably connected with each other via the hinge mechanism 2110.

As shown in Fig. 9, the second closing part 3112 will be in a state that it bends approximately perpendicularly to the first closing part 3111 at the time when it is open, and its bottom end touches a floor surface. By such closing member 3110, fall of the storage box 2100 on its front is prevented.

In addition, a pair of right and left pieces of box supporting member 3200 is connected rotatably in predetermined positions of the back or side faces of the storage box 2100. As shown in Fig. 9, by opening the pair of right and left box supporting members 3200 backward, fall of the storage box 2100 on its back is prevented.

According to the third exemplary embodiment described above, the same effect as the second exemplary embodiment can be obtained.

Furthermore, in the case of the third exemplary embodiment, fall of the storing box 2100 placed vertically on its front or its back can be prevented more certainly.

### (Fourth exemplary embodiment)

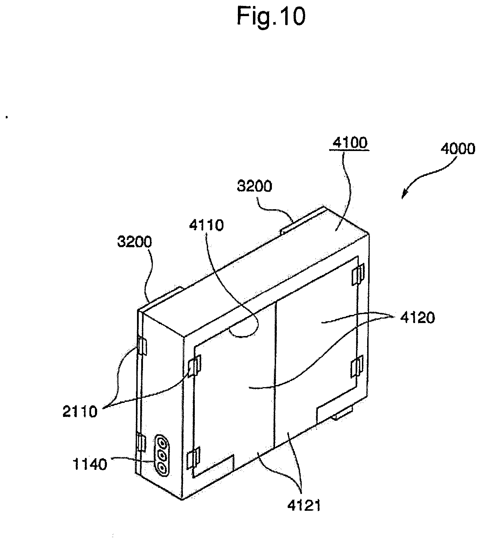

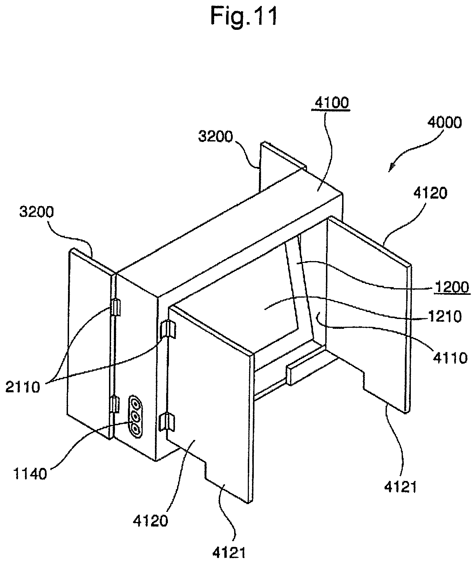

Fig. 10 and Fig. 11 indicate perspective views of a display carrier 4000 according to the fourth exemplary embodiment of the present invention, respectively. Fig. 10 is a perspective view of a state that a window part is closed, and Fig. 11 is a perspective view of a state that the window part is exposed. Meanwhile Fig. 10 and Fig. 11 indicate a state where the display carrier 4000 is placed vertically.

The structure of the display carrier 4000 is identical with that of the display carrier 3000 except for a part. Accordingly, an identical reference symbol is given to an identical component, and description of such components is omitted.

Each closing member 4120 of left and right is openably and closably attached to the left and right ends of a window part 4110 of a storage box 4100 via the hinge mechanism 2110. A box-supporting convex portion 4121 is formed in the lower end parts of each closing member 4120.

As shown in Fig. 11, because the box-supporting convex portion 4121 of each piece of closing member 4120 touches a floor surface when being open, fall of the storage box 4100 on its front is prevented.

According to the fourth exemplary embodiment described above, the same effect as the third exemplary embodiment can be obtained.

### [Industrial Applicability]

The present invention can be widely applied to the carrying of a display and equipment similar to a display.

### [Reference Signs List]

- 1000: Display carrier
- 1100: Storage box
- 1110: Window part
- 1120: Fixing member
- 1130: Closing member
- 1150: Supporting member
- 1200: Display
- 1210: Display screen
- 2000: Display carrier
- 2100: Storage box
- 2110: Hinge mechanism
- 2131: Closing member
- 2132: Closing member
- 2133: Closing member
- 2134: Closing member
- 2200: Stopper
- 2300: Leg part
- 3000: Display carrier
- 3110: Closing member
- 3111: First closing part
- 3112: Second closing part
- 3200: Box supporting member
- 4000: Display carrier
- 4100: Storage box
- 4110: Window part
- 4120: Closing member
- 4121: Box-supporting convex portion

## Claims

1. A display carrier (1000), comprising:
a storage box (1100) which stores a display (1200);
a fixing member (1120) which fixes said display (1200) in the inside of said storage box (1100);
a window part (1110) which is formed on a face which is opposite to a screen (1210) of said display (1200) with said display (1200) being fixed in the inside of said storage box (1100) among a plurality of faces of said storage box (1100); and
a pair of closing members (2131, 2132) which closes said window part (1110),
wherein
said pair of said closing members (2131, 2132) is attached to a periphery of said window part (1110) being an upper side and a periphery of said window part (1110) being a lower side, when the display carrier (1000) is placed vertically,
wherein
all of said closing members (2131, 2132) are rotatably attached to predetermined positions of said storage box (2100).

2. A display carrier (1000), comprising:
a storage box (1100) which stores a display (1200);
a fixing member (1120) which fixes said display (1200) in the inside of said storage box (1100);
a window part (1110) which is formed on a face which is opposite to a screen (1210) of said display (1200) with said display (1200) being fixed in the inside of said storage box (1100) among a plurality of faces of said storage box (1100); and
a pair of closing members (2131, 2132) which closes said window part (1110),
wherein
said pair of said closing members (2131, 2132) is attached to a periphery of said window part (1110) being a left side and to a periphery of said window part being a right side, when the display carrier (1000) is placed vertically,
wherein all of said closing members (2131, 2132) are rotatably attached to predetermined positions of said storage box (2100).

3. A display carrier (1000), comprising:
a storage box (1100) which stores a display (1200);
a fixing member (1120) which fixes said display (1200) in the inside of said storage box (1100);
a window part (1110) which is formed on a face which is opposite to a screen (1210) of said display (1200) with said display (1200) being fixed in the inside of said storage box (1100) among a plurality of faces of said storage box (1100); and
at least two pairs of closing members (2131, 2132, 2133, 2134) which close said window part (1110),
wherein
a first pair of said at least two pairs of said closing members (2131, 2132) is attached to a periphery of said window part (1110) being an upper side and a periphery of said window part being a lower side, when the display carrier (1000) is placed vertically;
a second pair of said at least two pairs of said closing members (2133, 2134) is attached to a periphery of said window part (1100) being a left side and a periphery of said window part being a right side, when the display carrier (1000) is placed vertically; and
said second pair of said at least two closing members (2133, 2134) support said closing member (2131) being attached to the periphery of said window part (1100) being the upper side, when the display carrier (1000) is placed vertically
wherein all of said closing members (2131, 2132, 2133, 2134) are rotatably attached to predetermined positions of said storage box (2100).

4. The display carrier (1000) according to claim 1, 2, or 3, wherein
said fixing member (1120) fixes said display (1200) at a position not allowing an outside face of said display (1200) to touch an inside face of said storage box (1100).

5. The display carrier (1000) according to any one of claims 1 to 4, wherein
a stopper (2200) for fixing a movement of said at least one closing member (1130) in order to maintain closing of said at least one closing member (1130) when at least one of said at least one closing member (1130) closing said window part (1110) is provided in a predetermined position of said storage box (1100).

6. A display carrier (1000) according to any one of claims 1 to 5,
wherein said fixing member (1120) fixes said display (1200) so that said screen (1210) inclines only a predetermined angle to said window part (1110).

7. A portable type display device, comprising:
a display carrier (1000) according to any one of claims 1-6; and
a display (1200) fixed by said fixing member (1120) in the inside of said storage box (1100).

## Patentansprüche

1. Display-Transportvorrichtung (1000), mit:
einer Aufbewahrungsbox (1100) zum Aufbewahren eines Displays (1200);
einem Befestigungselement (1120), das das Display (1200) im Inneren der Aufbewahrungsbox (1100) befestigt;
einem Fensterteil (1110), das auf einer einem Bildschirm (1210) des Displays (1200) gegenüberliegenden Seite ausgebildet ist, wobei das Display (1200) im Inneren der Aufbewahrungsbox (1100) zwischen mehreren Seiten der Aufbewahrungsbox (1100) befestigt ist; und
einem das Fensterteil (1110) verschließenden Paar von Schließelementen (2131, 2132),
wobei
das Paar von Schließelementen (2131, 2132) an einer Peripherie des Fensterteils (1110), die eine Oberseite bildet, und an einer Peripherie des Fensterteils (1110), die eine Unterseite bildet, angebracht ist, wenn die Display-Transportvorrichtung (1000) vertikal platziert ist,
wobei alle Schließelemente (2131, 2132) drehbar an vorbestimmten Positionen der Aufbewahrungsbox (2100) angebracht sind.

2. Display-Transportvorrichtung (1000), mit:
einer Aufbewahrungsbox (1100) zum Aufbewahren eines Displays (1200);
einem Befestigungselement (1120), das das Display (1200) im Inneren der Aufbewahrungsbox (1100) befestigt;
einem Fensterteil (1110), das auf einer einem Bildschirm (1210) des Displays (1200) gegenüberliegenden Seite ausgebildet ist, wobei das Display (1200) im Inneren der Aufbewahrungsbox (1100) zwischen mehreren Seiten der Aufbewahrungsbox (1100) befestigt ist; und
einem das Fensterteil (1110) verschließenden Paar von Schließelementen (2131, 2132),
wobei
das Paar von Schließelementen (2131, 2132) an einer Peripherie des Fensterteils (1110), die eine linke Seite bildet, und an einer Peripherie des Fensterteils (1110), die eine rechte Seite bildet, angebracht ist, wenn die Display-Transportvorrichtung (1000) vertikal platziert ist,
wobei alle Schließelemente (2131, 2132) drehbar an vorbestimmten Positionen der Aufbewahrungsbox (2100) angebracht sind.

3. Display-Transportvorrichtung (1000) mit:
einer Aufbewahrungsbox (1100) zum Aufbewahren eines Displays (1200);
einem Befestigungselement (1120), das das Display (1200) im Inneren der Aufbewahrungsbox (1100) befestigt;
einem Fensterteil (1110), das an einer dem Bildschirm (1210) des Displays (1200) entgegengesetzten Seite ausgebildet ist, wobei das Display (1200) im Inneren der Aufbewahrungsbox (1100) zwischen mehreren Seiten der Aufbewahrungsbox (1100) befestigt ist; und
mindestens zwei Paaren von Schließelementen (2131, 2132, 2133, 2134), die das Fensterteil (1110) verschließen,
wobei
ein erstes Paar der mindestens zwei Paare von Schließelementen (2131, 2132) an einer Peripherie des Fensterteils (1110), die eine Oberseite bildet, und an einer Peripherie des Fensterteils, die eine Unterseite bildet, angebracht ist, wenn die Display-Transportvorrichtung (1000) vertikal platziert ist;
ein zweites Paar der mindestens zwei Paare von Schließelementen (2133, 2134) an einer Peripherie des Fensterteils (1110), die eine linke Seite bildet, und einer Peripherie des Fensterteils, die eine rechte Seite bildet, angebracht ist, wenn die Display-Transportvorrichtung (1000) vertikal platziert ist; und
das zweite Paar der mindestens zwei Schließelemente (2133, 2134) das Schließelement (2131) stützt, das an der Peripherie des Fensterteils (1100) angebracht ist, die die Oberseite bildet, wenn die Display-Transportvorrichtung (1000) vertikal platziert ist,
wobei alle Schließelemente (2131, 2132, 2133, 2134) drehbar an vorbestimmten Positionen der Aufbewahrungsbox (2100) angebracht sind.

4. Display-Transportvorrichtung (1000) nach Anspruch 1, 2 oder 3, wobei
das Befestigungselement (1120) das Display (1200) an einer Position befestigt, die verhindert, dass eine äußere Oberfläche des Displays (1200) mit einer inneren Oberfläche der Aufbewahrungsbox (1100) in Berührung kommt.

5. Display-Transportvorrichtung (1000) nach einem der Ansprüche 1 bis 4, wobei
ein Anschlag (2200) zum Fixieren einer Bewegung des mindestens einen Schließelements (1130), um das mindestens eine Schließelement (1130) im geschlossenen Zustand zu halten, wenn mindestens eines von dem mindestens einen Schließelement (1130), das das Fensterteil (1110) verschließt, in einer vorbestimmten Position der Aufbewahrungsbox (1100) vorgesehen ist.

6. Display-Transportvorrichtung (1000) nach einem der Ansprüche 1 bis 5,
wobei das Befestigungselement (1120) das Display (1200) so befestigt, dass der Bildschirm (1210) sich nur um einen vorbestimmten Winkel gegenüber dem Fensterteil (1110) neigt.

7. Tragbare Display-Vorrichtung mit:
einer Display-Transportvorrichtung (1000) nach einem der Ansprüche 1 bis 6, und
einem mit dem Befestigungselement (1120) im Innern der Aufbewahrungsbox (1100) befestigten Display (1200).

## Revendications

1. Support d'afficheur (1000) comprenant :
une boîte de stockage (1100) qui stocke un afficheur (1200) ;
un élément de fixation (1120) qui fixe ledit afficheur (1200) à l'intérieur de ladite boîte de stockage (1100) ;
une partie de fenêtre (1110) qui est formée sur une face qui est opposée à un écran (1210) dudit afficheur (1200) avec ledit afficheur (1200) qui est fixé à l'intérieur de ladite boîte de stockage (1100) parmi une pluralité de faces de ladite boîte de stockage (1100) ; et
une paire d'éléments de fermeture (2131, 2132) qui ferme ladite partie de fenêtre (1110),
dans lequel :
ladite paire desdits éléments de fermeture (2131, 2132) est fixée sur une périphérie de ladite partie de fenêtre (1110) qui est un côté supérieur et une périphérie de ladite partie de fenêtre (1110) qui est un côté inférieur, lorsque le support d'afficheur (1000) est placé verticalement,
dans lequel tous lesdits éléments de fermeture (2131, 2132) sont fixés de manière rotative dans des positions prédéterminées de ladite boîte de stockage (2100).

2. Support d'afficheur (1000) comprenant :
une boîte de stockage (1100) qui stocke un afficheur (1200) ;
un élément de fixation (1120) qui fixe ledit afficheur (1200) à l'intérieur de ladite boîte de stockage (1100) ;
une partie de fenêtre (1110) qui est formée sur une face qui est opposée à un écran (1210) dudit afficheur (1200) avec ledit afficheur (1200) qui est fixé à l'intérieur de ladite boîte de stockage (1100) parmi une pluralité de faces de ladite boîte de stockage (1100) ; et
une paire d'éléments de fermeture (2131, 2132) qui ferme ladite partie de fenêtre (1110),
dans lequel :
ladite paire desdits éléments de fermeture (2131, 2132) est fixée à une périphérie de ladite partie de fenêtre (1110) qui est un côté gauche et à une périphérie de ladite partie de fenêtre qui est un côté droit, lorsque le support d'afficheur (1000) est placé verticalement, dans lequel tous lesdits éléments de fermeture (2131, 2132) sont fixés en rotation dans des positions prédéterminées de ladite boîte de stockage (2100).

3. Support d'afficheur (1000) comprenant :
une boîte de stockage (1100) qui stocke un afficheur (1200) ;
un élément de fixation (1120) qui fixe ledit afficheur (1200) à l'intérieur de ladite boîte de stockage (1100) ;
une partie de fenêtre (1110) qui est formée sur une face qui est opposée à un écran (1210) dudit afficheur (1200) avec ledit afficheur (1200) qui est fixé à l'intérieur de ladite boîte de stockage (1100) parmi une pluralité de faces de ladite boîte de stockage (1100) ; et
au moins deux paires d'éléments de fermeture (2131, 2132, 2133, 2134) qui ferme ladite partie de fenêtre (1110),
dans lequel :
une première paire desdites au moins deux paires desdits éléments de fermeture (2131, 2132) est fixée sur une périphérie de ladite partie de fenêtre (1110) qui est un côté supérieur et une périphérie de ladite partie de fenêtre qui est un côté inférieur, lorsque le support d'afficheur (1000) est placé verticalement ;
une seconde paire desdites au moins deux paires desdits éléments de fermeture (2133, 2134) est fixée sur une périphérie de ladite partie de fenêtre (1100) qui est un côté gauche et une périphérie de ladite partie de fenêtre qui est un côté droit, lorsque le support d'afficheur (1000) est placé verticalement ; et
ladite seconde paire desdits au moins deux éléments de fermeture (2133, 2134) supportent ledit élément de fermeture (2131) qui est fixé à la périphérie de ladite partie de fenêtre (1100) qui est le côté supérieur, lorsque le support d'afficheur (1000) est placé verticalement, dans lequel tous lesdits éléments de fermeture (2131, 2132, 2133, 2134) sont fixés en rotation dans les positions prédéterminées de ladite boîte de stockage (2100).

4. Support d'afficheur (1000) selon la revendication 1, 2 ou 3, dans lequel :
ledit élément de fixation (1120) fixe ledit afficheur (1200) dans une position ne permettant pas à une face extérieure dudit afficheur (1200) d'être en contact avec une face intérieure de ladite boite de stockage (1100).

5. Support d'afficheur (1000) selon l'une quelconque des revendications 1 à 4, dans lequel :
une butée (2200) pour fixer un mouvement dudit au moins un élément de fermeture (1130) afin de maintenir la fermeture dudit au moins un élément de fermeture (1130) lorsqu'au moins l'un dudit au moins un élément de fermeture (1130) fermant ladite partie de fenêtre (1110) est prévu dans une position prédéterminée de ladite boite de stockage (1100).

6. Support d'afficheur (1000) selon l'une quelconque des revendications 1 à 5,
dans lequel ledit élément de fixation (1120) fixe ledit afficheur (1200) de sorte que ledit écran (1210) s'incline uniquement à un angle prédéterminé par rapport à ladite partie de fenêtre (1110).

7. Dispositif d'afficheur de type portable comprenant :
un support d'afficheur (1000) selon l'une quelconque des revendications 1 à 6 ; et
un afficheur (1200) fixé par ledit élément de fixation (1120) à l'intérieur de ladite boîte de stockage (1100).
